# EUROPEAN PATENT APPLICATION

(11) **EP 2 698 820 A2**
(43) Date of publication of application: **19.02.2014**
(21) Application number: 13003660.1
(22) Date of filing: 22.07.2013
(51) Int. Cl.: H01L 27/02, H01L 27/118

(54) **Layout circuit optimization for deep submicron technologies**

(30) Priority: 17.08.2012 US 201261684655 P; 27.09.2012 US 201213628839
(71) Applicant: Broadcom Corporation, Irvine, CA 92617 (US)
(72) Inventor: Bitterlich, Stefan, Costa Mesa, CA 92627 (US)
(74) Representative: Jehle, Volker Armin

(57) **Abstract**

An integrated circuit is disclosed that has substantially continuous active diffusion regions within its diffusion layers. Active regions of semiconductor devices can be fabricated using portions of these substantially continuous active diffusion regions. Stress can be applied to these semiconductor devices during their fabrication which leads to substantially uniform stress patterns throughout the integrated circuit. The substantially uniform stress patterns can significantly improve performance of the integrated circuit.

## Description

### CROSS-REFERENCE TO RELATED APPLICATIONS

The present application claims the benefit of U.S. Provisional Patent Appl. No. 61/684,655, filed August 17, 2012, which is incorporated herein by reference in its entirety.

### BACKGROUND

### Field of Disclosure

The present disclosure relates generally to optimizing an integrated circuit layout, and more specifically to optimizing the integrated circuit layout to provide substantially uniform stress patterns to improve performance of the integrated circuit.

### Related Art

An integrated circuit is designed to have stress, also referred to as strain, applied to its semiconductor devices during their fabrication to improve performance. One type of stress imposes a mechanical stress or strain onto channel regions of the semiconductor devices to increase carrier or hole mobility to improve their speed. For example, a tensile mechanical strain and a compressive mechanical stress can be imposed on a p-type metal-oxide-semiconductor (PMOS) device and an n-type metal-oxide-semiconductor (NMOS) device, respectively, to improve their speed. New complementary metal-oxide-semiconductor (CMOS) nodes, such as 20nm and below, apply the stress during their fabrication to diffusion layers, polysilicon layers, metal layers, and/or interconnections between layers of the semiconductor devices to improve performance.

Typically, the integrated circuit is usually constructed using configurations and arrangements of semiconductor devices that are selected from a predefined library of standard cells. A standard cell represents one or more semiconductor devices as well as their interconnection structures that are configured and arranged to provide a Boolean logic function, such as AND, OR, XOR, XNOR, or NOT to provide some examples, or a storage function, such as a flipflop or a latch to provide some examples. The simplest standard cells are direct representations of the elemental NAND, NOR, XOR, or NOT Boolean logic functions, although standard cells of much greater complexity are commonly used, such as a 2-bit full-adder to provide an example. The standard cells are defined in terms of planar geometric shapes which correspond to diffusion layers, polysilicon layers, metal layers, and/or interconnections between layers.

Conventionally, active diffusion regions, also referred to as oxide diffusion (OD) regions or thin oxide regions, within diffusion layers which form transistors of one standard cell are separated from active diffusion regions within diffusion layers of another standard cell by a physical active diffusion region gap. The physical active diffusion region gap causes discontinuities in the diffusion layer, often referred to as edge effects, which lead to non-uniform stress patterns when stress is applied to the semiconductor devices during fabrication. This non-uniform stress pattern can significantly reduce the performance of the integrated circuit, and is particularly acute for newer CMOS nodes, such as 20nm.

### BRIEF SUMMARY OF THE INVENTION

According to an aspect, an integrated circuit is provided having a substantially uniform stress pattern throughout when stress is applied during fabrication, comprising:
a first standard cell having a first active diffusion region and a second active diffusion region, a first transistor from among a plurality transistors being configured to utilize the first active diffusion region for its active region and a second first transistor from among the plurality transistors being configured to utilize the second active diffusion region for its active region;
a coupling cell having a third active diffusion region coupled to the first active diffusion region and a fourth active diffusion region coupled to the second active diffusion region, a third transistor from among the plurality transistors being configured to utilize the second active diffusion region for its active region and a fourth transistor from among the plurality transistors being configured to utilize the fourth active diffusion region for its active region, the third transistor and the fourth transistor being further configured to be continuously inactive; and
a second standard cell having a fifth active diffusion region coupled to the third active diffusion region and a sixth active diffusion region coupled to the fourth active diffusion region, a fifth transistor from among the plurality transistors being configured to utilize the fifth active diffusion region for its active region and a sixth transistor from among the plurality transistors being configured to utilize the sixth active diffusion region for its active region.

Advantageously, at least one of: the first standard cell or the second standard cell is selected from a pre-defined library of standard cells.

Advantageously, the first, the third, and the fifth active diffusion regions are configured and arranged to form a first substantially continuous active diffusion region, and wherein the second, the fourth, and the sixth active diffusion regions are configured and arranged to form a second substantially continuous active diffusion region.

Advantageously, the first, the third, and the fifth semiconductor transistors are p-type metal-oxide-semiconductor (PMOS) transistors and wherein the second, the fourth, and the sixth semiconductor transistors are n-type metal-oxide-semiconductor (NMOS) devices.

Advantageously, the third transistor is configured to continuously receive a bias voltage between its gate and its source that is greater than its threshold voltage to cause the third transistor to be continuously inactive.

Advantageously, the gate and the source of the third transistor are coupled to each to cause the third transistor to be continuously inactive.

Advantageously, the fourth transistor is configured to continuously receive a bias voltage between its gate and its source that is less than its threshold voltage to cause the fourth transistor to be continuously inactive.

According to an aspect, an integrated circuit is provided having a substantially continuous active diffusion region throughout, comprising
a first plurality of semiconductor devices configured to utilize the substantially continuous active diffusion region for their active regions, the first plurality of transistors having a first integrated circuit layout that is selected from a pre-defined library of standard cells;
a second plurality of semiconductor devices configured to be continuously inactive and to utilize the substantially continuous active diffusion region for their active regions; and
a third plurality of semiconductor devices configured to utilize the substantially continuous active diffusion region for their active regions, the third plurality of transistors having a second integrated circuit layout that is selected from the pre-defined library of standard cells.

Advantageously, the second plurality of semiconductor devices comprise:
a p-type metal-oxide-semiconductor (PMOS) device configured to continuously receive a first bias voltage between its gate and its source that is greater than its threshold voltage to cause the PMOS device to be continuously inactive; and
an n-type metal-oxide-semiconductor (NMOS) device configured to continuously receive a second bias voltage between its gate and its source that is less than its threshold voltage to cause the NMOS device to be continuously inactive.

Advantageously, the integrated circuit further comprises:
a first metal region configured to provide the first bias voltage; and
a second metal region configured to provide the second bias voltage,
wherein the gate and the source of the PMOS device and the gate and the source of the NMOS are coupled to the first metal region and the second metal region, respectively.

Advantageously, the PMOS device and the NMOS device are configured and arranged to form a transmission gate that is continuously inactive.

Advantageously, the second plurality of semiconductor devices are configured to share common interconnections with the first plurality of semiconductor devices or the third plurality of semiconductor devices.

Advantageously, the integrated circuit is characterized as having a substantially uniform stress pattern throughout when stress is applied to the first, the second, and the third plurality of semiconductor devices.

According to an aspect, a coupling cell is provided for coupling a first active diffusion region of a first standard cell to a second active diffusion region of a second standard cell, comprising:
a third active diffusion region coupled to the first active diffusion region and the second active diffusion region to form a substantially continuous active diffusion region throughout; and
a semiconductor device configured to utilize the substantially continuous active diffusion region for its respective active region, the semiconductor device being configured to be inactive.

Advantageously, the semiconductor device comprises:
a p-type metal-oxide-semiconductor (PMOS) device configured to continuously receive a bias voltage between its gate and its source that is greater than its threshold voltage to cause the PMOS device to be continuously inactive or to receive a control signal at the gate that is greater than the threshold voltage to cause the PMOS device to be temporarily inactive.

Advantageously, the source of the PMOS device is coupled to the gate.

Advantageously, the semiconductor device comprises:
a n-type metal-oxide-semiconductor (NMOS) device configured to continuously receive a bias voltage between its gate and its source that is less than its threshold voltage to cause the NMOS device to be continuously inactive or to receive a control signal at the gate that is less than the threshold voltage to cause the NMOS device to be temporarily inactive.

Advantageously, a source of the NMOS device is coupled to the gate.

Advantageously, a width of the first active diffusion region is different from a width of the second active diffusion region, and
wherein the third active diffusion region is configured to provide a substantially continuous transition from the first active diffusion region to the second active diffusion region.

Advantageously, the substantially continuous transition is a substantially non-linear transition.

### BRIEF DESCRIPTION OF THE DRAWINGS/FIGURES

Embodiments of the disclosure are described with reference to the accompanying drawings. In the drawings, like reference numbers indicate identical or functionally similar elements. Additionally, the left most digit(s) of a reference number identifies the drawing in which the reference number first appears.

FIG. 1 illustrates a conventional integrated circuit layout of a conventional integrated circuit;

FIG. 2 illustrates a conventional integrated circuit layout of a second conventional integrated circuit.

FIG. 3 illustrates a first integrated circuit layout of a first integrated circuit according to an exemplary embodiment of the present disclosure;

FIG. 4 illustrates a second integrated circuit layout of a second integrated circuit according to an exemplary embodiment of the present disclosure; and

FIG. 5 illustrates a third integrated circuit layout of a third integrated circuit according to an exemplary embodiment of the present disclosure.

The disclosure will now be described with reference to the accompanying drawings. In the drawings, like reference numbers generally indicate identical, functionally similar, and/or structurally similar elements. The drawing in which an element first appears is indicated by the leftmost digit(s) in the reference number.

### DETAILED DESCRIPTION OF THE DISCLOSURE

The following Detailed Description refers to accompanying drawings to illustrate exemplary embodiments consistent with the disclosure. References in the Detailed Description to "one exemplary embodiment," "an exemplary embodiment," "an example exemplary embodiment," etc., indicate that the exemplary embodiment described can include a particular feature, structure, or characteristic, but every exemplary embodiment can not necessarily include the particular feature, structure, or characteristic. Moreover, such phrases are not necessarily referring to the same exemplary embodiment. Further, when a particular feature, structure, or characteristic is described in connection with an exemplary embodiment, it is within the knowledge of those skilled in the relevant art(s) to affect such feature, structure, or characteristic in connection with other exemplary embodiments whether or not explicitly described.

The exemplary embodiments described herein are provided for illustrative purposes, and are not limiting. Other exemplary embodiments are possible, and modifications can be made to the exemplary embodiments within the spirit and scope of the disclosure. Therefore, the Detailed Description is not meant to limit the disclosure. Rather, the scope of the disclosure is defined only in accordance with the following claims and their equivalents.

The following Detailed Description of the exemplary embodiments will so fully reveal the general nature of the disclosure that others can, by applying knowledge of those skilled in relevant art(s), readily modify and/or adapt for various applications such exemplary embodiments, without undue experimentation, without departing from the spirit and scope of the disclosure. Therefore, such adaptations and modifications are intended to be within the meaning and plurality of equivalents of the exemplary embodiments based upon the teaching and guidance presented herein. It is to be understood that the phraseology or terminology herein is for the purpose of description and not of limitation, such that the terminology or phraseology of the present specification is to be interpreted by those skilled in relevant art(s) in light of the teachings herein.

CONVENTIONAL INTEGRATED CIRCUIT LAYOUT

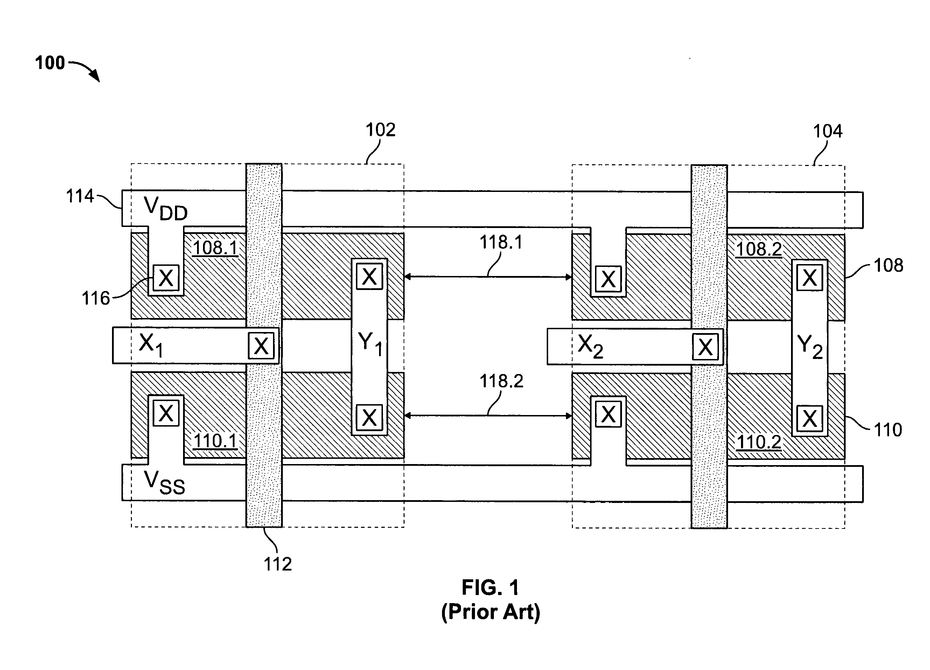

FIG. 1 illustrates a conventional integrated circuit layout of a conventional integrated circuit. A conventional integrated circuit 100 includes multiple standard cells that are selected from a predefined library of standard cells. These standard cells include one or more semiconductor devices that are fabricated onto diffusion layers, polysilicon layers, and/or metal layers of a semiconductor substrate and include interconnections between these layers. Stress can be applied to the diffusion layers during fabrication of the one or more semiconductor devices to improve their performance. However, active diffusion regions within the diffusion layers of one standard cell of the conventional integrated circuit 100 are separated from active diffusion regions within the diffusion layers of another standard cell of the conventional integrated circuit 100 by a physical active diffusion region gap. The physical active diffusion region gap causes discontinuities, often referred to as edge effects, between these active diffusion regions that lead to non-uniform stress patterns when stress is applied to the semiconductor devices within the conventional integrated circuit 100. These non-uniform stress patterns significantly reduce performance of the conventional integrated circuit 100. The conventional integrated circuit 100 includes a first standard cell 102 and a second standard cell 104.

The standard cells 102 and 104 can represent any suitable standard cells that are selected from the predefined library of standard cells. Although these standard cells are illustrated as being conventional integrated circuit layouts of conventional inverters, this is for illustrative purposes only. The standard cells 102 and 104 can be implemented using any conventional integrated circuit layouts that are configured and arranged to provide Boolean logic functions, such as AND, OR, XOR, XNOR, or NOT to provide some examples, or storage functions, such as a flipflop or a latch to provide some examples.

Conventionally, the standard cells 102 and 104 include semiconductor devices that are defined in terms of planar geometric shapes which correspond to first active diffusion regions 108.1 and 108.2 and second active diffusion regions 110.1 and 110.2 within one or more diffusion layers, polysilicon regions 112 within one or more polysilicon layers, metal regions 114 within one or more metal layers and/or one or more interconnections 116, such as contacts or vias to provide some examples, between the regions. The active diffusion regions 108 and 110, illustrated using hashing in FIG. 1, represent active diffusion regions upon which active regions of the semiconductor devices can be formed. The polysilicon regions 112, illustrated using dotted shading in FIG. 1, overlap the active diffusion regions to form the semiconductor devices. Typically, the first active diffusion regions 108.1 and 108.2 are doped with impurity atoms of an acceptor type, such as boron or aluminum to provide some examples, that are capable of accepting an electron to form active regions of p-type metal-oxide-semiconductor (PMOS) devices. The second active diffusion regions 110.1 and 110.2 are doped with impurity atoms of a donor type, such as phosphorus, arsenic, or antimony to provide some examples, that are capable of donating an electron to form active regions of n-type metal-oxide-semiconductor (NMOS) devices. The polysilicon regions 112 can be doped with impurity atoms of the acceptor type or of the donor type. Although not shown, the semiconductor devices, as well other semiconductor devices to be described below, can be formed within specially implanted regions, known as wells, that can increase the number of carrier holes and/or carrier electrons located in the semiconductor substrate. The semiconductor substrate can be implanted with the atoms of the acceptor type and atoms of the donor type to fabricate a specially implanted p-type well region and a specially implanted n-type well region, respectively.

The metal regions 114, illustrated using solid gray shading in FIG. 1, represent regions of metal within the one or more metal layers for routing of signals within the standard cells 102 and 104 or between the standard cells 102 and 104. For example, some of the metal regions 114 route a supply voltage V_{SS} and supply voltage V_{DD} to the transistors of the standard cells 102 and 104. As another example, some of the metal regions 114 route input signals X₁ and X₂ to the standard cells 102 and 104 or output signals Y₁ and Y₂ from the standard cells 102 and 104.

The one or more interconnections 116, illustrated as a squared "x" in FIG. 1, couple regions within the conventional integrated circuit 100. Typically, the one or more interconnections 116 can include contacts to form interconnections between the active diffusion regions 108 and/or 110 and the metal regions 114 and/or between the polysilicon regions 112 and the metal regions 114. Additionally, the one or more interconnections 116 can include vias to form interconnections between the metal regions 114.

As illustrated in FIG. 1, the first active diffusion region 108.1 and the second active diffusion region 110.1 are separated from the first active diffusion region 108.2 and the second active diffusion region 110.2, respectively, by a physical active diffusion region gap 118. The physical active diffusion region gap 118 includes a first physical active diffusion region gap 118.1 between the first active diffusion region 108.1 and the first active diffusion region 108.2 and a second physical active diffusion region gap 118.2 between the second active diffusion region 110.1 and the second active diffusion region 110.2. The physical active diffusion region gap 118 causes discontinuities in the one or more diffusion layers, often referred to as edge effects, which lead to a non-uniform stress pattern in the conventional integrated circuit 100. This non-uniform stress pattern can significantly reduce the performance of the conventional integrated circuit 100 and is particularly acute for newer CMOS nodes, such as 20nm.

CONVENTIONAL INTEGRATED CIRCUIT LAYOUT

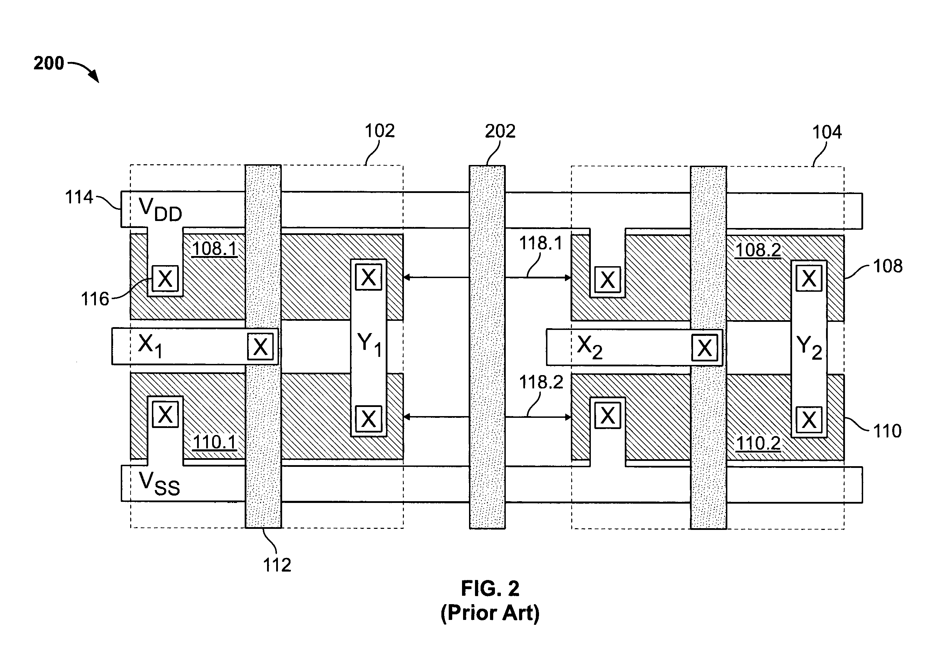

FIG. 2 illustrates a conventional integrated circuit layout of a second conventional integrated circuit. A conventional integrated circuit 200 is substantially similar to the conventional integrated circuit 100; however, the polysilicon regions 112 within the one or more polysilicon layers of the conventional integrated circuit 200 additionally include a polysilicon region 202 within the physical active diffusion region gap 118. The polysilicon region 202 is conventionally utilized to maintain symmetry within the one or more polysilicon layers and can be implemented to create a substantially uniform polysilicon for advanced technology nodes such as 28nm and below to provide some examples.

OVERVIEW

The following Detailed Description describes an integrated circuit that has substantially continuous active diffusion regions within its diffusion layers throughout the integrated circuit. Active regions of semiconductor devices can be fabricated using portions of these substantially continuous active diffusion regions. Stress can be applied to these semiconductor devices during their fabrication which leads to uniform stress patterns throughout the integrated circuit. The substantially uniform stress patterns can significantly improve performance of the integrated circuit when compared to the conventional integrated circuit 100 and/or the conventional integrated circuit 200.

FIRST INTEGRATED CIRCUIT LAYOUT

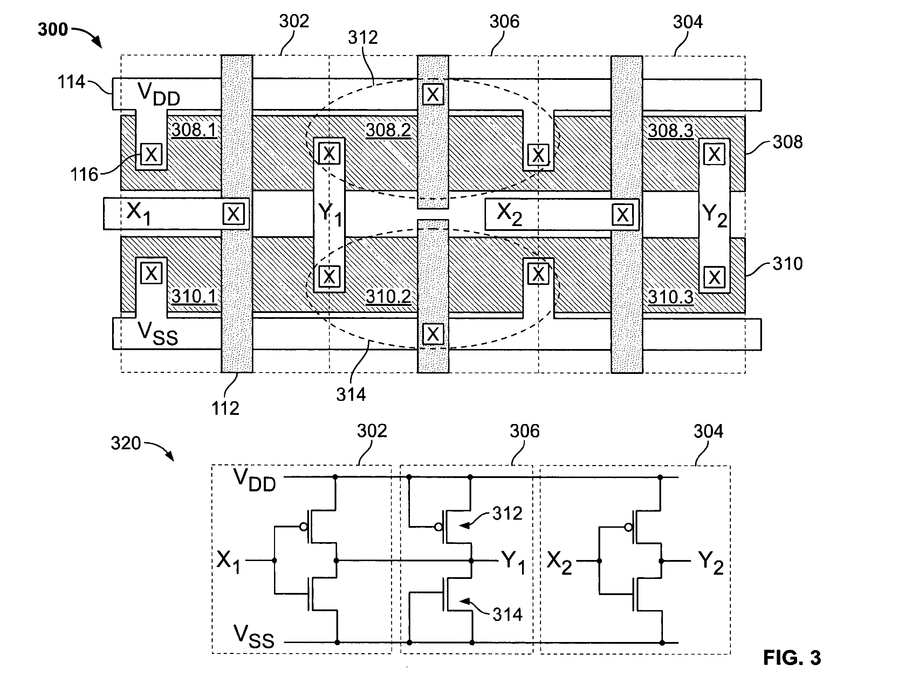

FIG. 3 illustrates a first integrated circuit layout of a first integrated circuit according to an exemplary embodiment of the present disclosure. An integrated circuit 300 includes multiple standard cells that are selected from a predefined library of standard cells. These standard cells include one or more semiconductor devices that are fabricated onto diffusion layers, polysilicon layers, and/or metal layers of a semiconductor substrate and include interconnections between these layers. The standard cells can share substantially continuous active diffusion regions within the diffusion layers. Stressing semiconductor devices can be fabricated using portions of these substantially continuous active diffusion regions for their active regions. Stress can be applied to these stressing semiconductor devices during their fabrication which leads to uniform stress patterns throughout the integrated circuit 300. The substantially uniform stress patterns can significantly improve performance of the integrated circuit 300. The integrated circuit 300 includes a first standard cell 302, a second standard cell 304, and a coupling cell 306.

The first standard cell 302 and the second standard cell 304 can represent any standard cells that are selected from the predefined library of standard cells in a substantially similar manner as the standard cells 102 and 104. The first standard cell 302 and the second standard cell 304 can be implemented using any integrated circuit layouts that are configured and arranged to provide Boolean logic functions, such as AND, OR, XOR, XNOR, or NOT to provide some examples, or storage functions, such as a flipflop or a latch to provide some examples. The simplest implementations for the first standard cell 302 and the second standard cell 304 are direct representations of the elemental NAND, NOR, XOR, or NOT Boolean logic functions, although implementations of much greater complexity can be used.

The first standard cell 302 and the second standard cell 304 include semiconductor devices that are defined in terms of planar geometric shapes which correspond to the polysilicon regions 112 within the one or more polysilicon layers, the metal regions 112 within the one or more metal layers, the one or more interconnections 116, and a first active diffusion region 308 and a second active diffusion region 310 within one or more diffusion layers. The first active diffusion region 308 and the second active diffusion region 310, illustrated using hashing in FIG. 3, represent active diffusion regions of a semiconductor substrate upon which active regions of the semiconductor devices can be formed. The polysilicon regions 112 overlap the active diffusion regions to form the semiconductor devices. Typically, the first active diffusion region 308 is doped with impurity atoms of the acceptor type to form active regions of PMOS devices and the second active diffusion region 310 is doped with impurity atoms of the donor type to form active regions of NMOS devices. The first active diffusion region 308 can be characterized as being a combination of a first active diffusion region portion 308.1 within the first standard cell 302, a second active diffusion region portion 308.2 between the first standard cell 302 and the second standard cell 304, and a third active diffusion region portion 308.3 within the second standard cell 304. The second active diffusion region 310 can be characterized in a substantially similar manner as the first active diffusion region 308.

The coupling cell 306 couples the first active diffusion region portion 308.1 to the third active diffusion region portion 308.3 and the first active diffusion region portion 310.1 to the third active diffusion region portion 310.3 to provide substantially continuous active diffusion regions within the integrated circuit 300. Specifically, the coupling cell 306 provides a substantially continuous transition of the first active diffusion region portion 308.1 to the third active diffusion region portion 308.3 and a substantially continuous transition of the first active diffusion region portion 310.1 to the third active diffusion region portion 310.3. Accordingly, there are no physical active diffusion region gaps between the first active diffusion region portion 308.1 and third active diffusion region portion 308.3 and between the first active diffusion region portion 310.1 and third active diffusion region portion 310.3. These substantially continuous transitions of the first active diffusion region 308 and the second active diffusion region 310 provide for substantially uniform stress patterns throughout the integrated circuit 300 when stress is applied to the semiconductor devices during their fabrication.

For example, as illustrated in FIG. 3, the coupling cell 306 includes a p-type stressing transistor 312 and an n-type stressing transistor 314. Although the p-type stressing transistor 312 and an n-type stressing transistor 314 are illustrated as being a PMOS transistor and an NMOS transistor, respectively, those skilled in the relevant art(s) will recognize that other types of transistors can be used without departing from the spirit and scope of the present disclosure. Active regions of the p-type stressing transistor 312 and of the n-type stressing transistor 314 are fabricated using the second active diffusion region portion 308.2 and the second active diffusion region portion 310.2, respectively. The polysilicon regions 112 overlap the second active diffusion region portion 308.2 and the second active diffusion region portion 310.2 to form the p-type stressing transistor 312 and the n-type stressing transistor 314. Although the polysilicon regions 112 are illustrated as being equidistant from the first standard cell 302 and the second standard cell 304, this is for illustrative purposes only. Those skilled in the relevant art(s) will recognize that the p-type stressing transistor 312 and the n-type stressing transistor 314, as well other stressing transistors to be described below, can be closer to either the first standard cell 302 or the second standard cell 304 without departing from the spirit and scope of the present disclosure. In some situations, a drain region of the p-type stressing transistor 312 and a drain region of the n-type stressing transistor 314 can share common interconnections 116 with transistors of the first standard cell 302 and/or common interconnections 116 with transistors of the second standard cell 304. In other situations, a source region of the p-type stressing transistor 312 and a source region of the n-type stressing transistor 314 can share common interconnections 116 with transistors of the second standard cell 304 and/or common interconnections 116 with transistors of the second standard cell 304. However, other integrated circuit layouts for the p-type stressing transistor 312 and the n-type stressing transistor 314 are possible as will be apparent to those skilled in the relevant art(s) without departing from the spirit and scope of the present disclosure. When stress is applied to the second active diffusion region portion 308.2 and the second active diffusion region portion 310.2 during fabrication of the p-type stressing transistor 312 and of the n-type stressing transistor 314, respectively, substantially uniform stress patterns are provided throughout the integrated circuit 300.

Although the coupling cell 306, as well as other coupling cells to be described below, is described in terms of connecting standard cells, those skilled in the relevant art(s) will recognize that the disclosure can be applied naturally and usually to complete standard cells rows and regions by inserting a coupling cell between many or all standard cells. Typically, the coupling cell would be added between all neighboring standard cells which are speed critical. It can be used for any subset of the cells depending on the designer's requirements.

Additionally, to ensure that the p-type stressing transistor 312 and the n-type stressing transistor 314 do not adversely affect operation of the first standard cell 302, the p-type stressing transistor 312 and the n-type stressing transistor 314 can be biased to be continuously inactive or turned "OFF." These continuously inactive semiconductor transistors, as well other continuously inactive semiconductor transistors to be described below, can be referred to as "dummy" transistors. The p-type stressing transistor 312 is biased to be continuously inactive by continuously applying a voltage that is greater than its threshold voltage between its gate and its source. Typically, the threshold voltage of the p-type stressing transistor 312 is a negative voltage; therefore, applying this voltage between its gate and its source inactivates the p-type stressing transistor 312. Likewise, n-type stressing transistor 314 is biased to be continuously inactive by continuously applying a voltage that is less than its threshold voltage between its gate and its source. Typically, the threshold voltage of the n-type stressing transistor 314 is a positive voltage; therefore, applying this voltage between its gate and its source inactivates the n-type stressing transistor 314. For example, a source and the gate of the p-type stressing transistor 312 and a source and the gate of the n-type stressing transistor 314 are coupled to the supply voltage V_{DD} and supply voltage V_{SS}, respectively, as illustrated in a circuit diagram 320 for the integrated circuit 300.

In this example, coupling of the source and the gate of the p-type stressing transistor 312 to the supply voltage V_{DD} ensures that voltage between its gate and its source is greater than the threshold voltage and coupling of the source and the gate of the n-type stressing transistor 314 to the supply voltage V_{SS} ensures that voltage between its gate and its source is less than the threshold voltage. As a result of the voltage between the gate and the source of the p-type stressing transistor 312 being greater than the threshold voltage and the voltage between the gate and the source of the n-type stressing transistor 314 being less than the threshold voltage, the p-type stressing transistor 312 and the n-type stressing transistor 314 are continuously inactive. Typically, the supply voltage V_{DD} represents a voltage that corresponds to a logical one and the supply voltage V_{SS} represents a voltage that corresponds to a logical zero or ground.

Alternatively, to ensure that the p-type stressing transistor 312 and the n-type stressing transistor 314 do not adversely affect operation of the first standard cell 302, the p-type stressing transistor 312 and the n-type stressing transistor 314 can be biased to be temporarily inactive or turned "OFF." For example, the gate of the p-type stressing transistor 312 and the gate of the n-type stressing transistor 314 are coupled to various control signals that are configured to bias the gate of the p-type stressing transistor 312 and the gate of the n-type stressing transistor 314 to make these transistors temporarily inactive. These various control signals can be provided by an output of another gate, a flipflop, a latch, a register, another standard cell or another semiconductor device to provide some examples. In an exemplary embodiment, these control signals can be provided through one or more outputs of one or more registers which are set-up to a correct value to bias the gate of the p-type stressing transistor 312 and the gate of the n-type stressing transistor 314 to make these transistors temporarily inactive at boot-up or before operation of the first standard cell 302 and the second standard cell 304.

SECOND INTEGRATED CIRCUIT LAYOUT

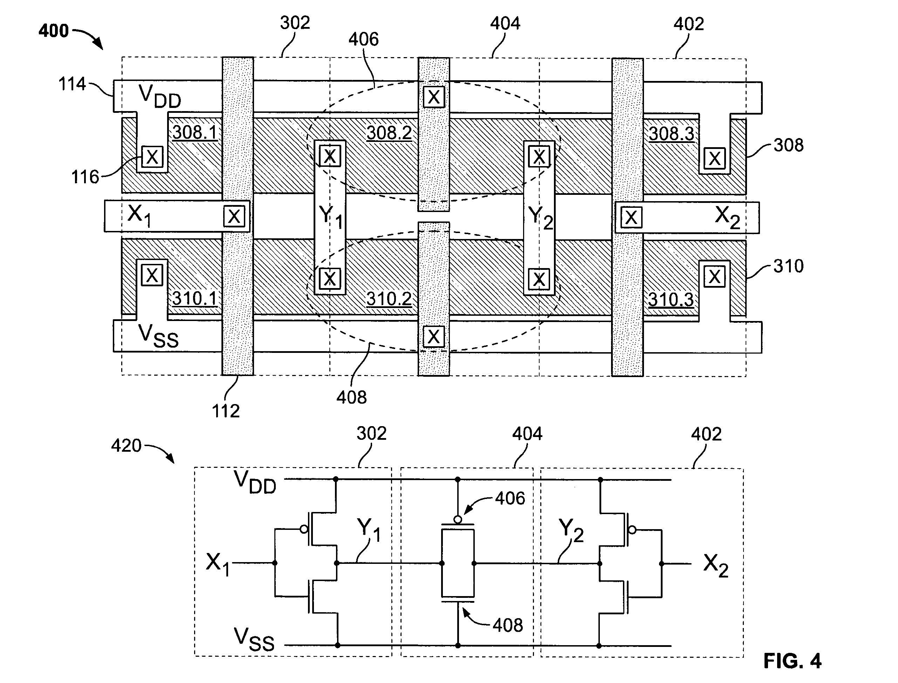

FIG. 4 illustrates a second integrated circuit layout of a second integrated circuit according to an exemplary embodiment of the present disclosure. An integrated circuit 400 is substantially similar to the integrated circuit 300; however, an integrated circuit layout of a standard cell 402 is a mirror image of an integrated circuit layout of the first standard cell 302. As a result, the configuration and arrangement of a p-type stressing transistor 406 and a n-type stressing transistor 408 differ from the p-type stressing transistor 312 and the n-type stressing transistor 314, respectively.

As shown in FIG. 4, a source region of the p-type stressing transistor 406 and a source region of the n-type stressing transistor 314 can share common interconnections 116 with NMOS transistors of the first standard cell 302 and common interconnections 116 with PMOS transistors of the first standard cell 302, respectively. This configuration and arrangement of the p-type stressing transistor 406 and the n-type stressing transistor 408 forms a transmission gate. However, coupling of a gate of the p-type stressing transistor 406 to the supply voltage V_{DD} and a gate of the n-type stressing transistor 408 to the supply voltage V_{SS} ensures that the transmission gate is continuously inactive.

THIRD INTEGRATED CIRCUIT LAYOUT

As illustrated in FIG. 3 through FIG. 4, the semiconductor devices within the first standard cell 302 and the semiconductor devices within the second standard cell 304 have substantially similar widths. For example, semiconductor devices whose active regions utilize the first active diffusion region portion 308.1 or the first active diffusion region portion 310.1 have substantially similar widths as semiconductor devices whose active regions utilize the third active diffusion region portion 308.3 or the third active diffusion region portion 310.3, respectively. As illustrated in FIG. 3 through FIG. 4, a width of the semiconductor devices is characterized as being a substantially vertical distance, or width, of the first active diffusion region 308 and/or the second active diffusion region 310. However, in some situations, the semiconductor devices within the first standard cell 302 have different widths than the semiconductor devices within second standard cell 304. In these situations, the first active diffusion region portion 308.1 and the first active diffusion region portion 310.1 continuously transition to the third active diffusion region portion 308.3 and the third active diffusion region portion 310.3, respectively.

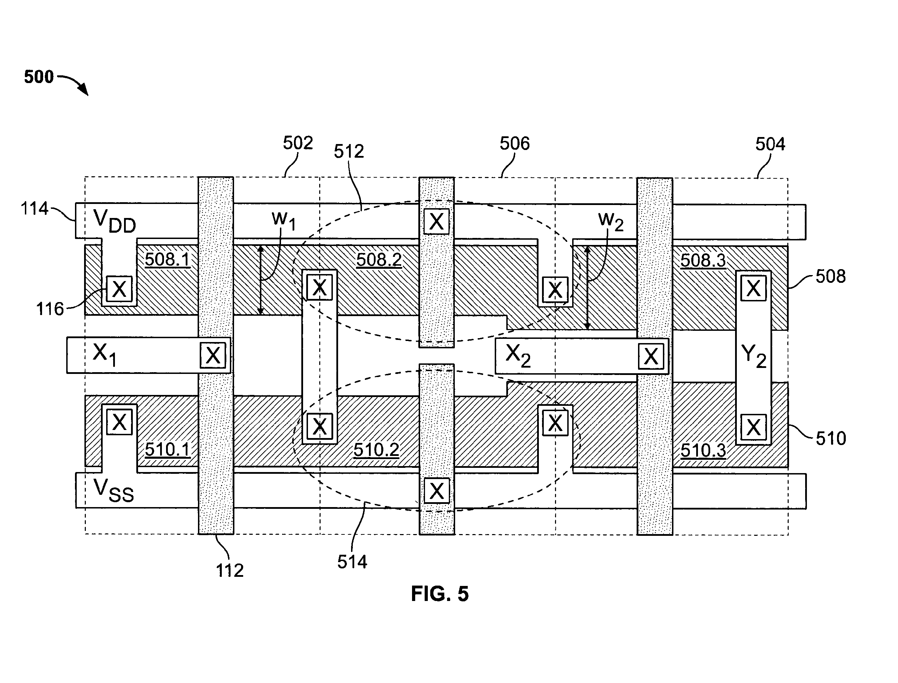

FIG. 5 illustrates a third integrated circuit layout of a fourth integrated circuit according to an exemplary embodiment of the present disclosure. An integrated circuit 500 includes multiple standard cells that are selected from a predefined library of standard cells. These standard cells include one or more semiconductor devices that are fabricated onto diffusion layers, polysilicon layers, and/or metal layers of a semiconductor substrate and include interconnections between these layers. The one or more semiconductor devices within one of the multiple standard cells have substantially different widths as one or more semiconductor devices within another one of the multiple standard cells. The integrated circuit 500 continuously transitions between active diffusion regions of the multiple standard cells to present substantially continuous active diffusion regions throughout the integrated circuit 500. Stress can be applied to stressing semiconductor devices within the substantially continuous active diffusion regions during their fabrication which leads to substantially uniform stress patterns throughout the integrated circuit 500. The substantially uniform stress patterns can significantly improve performance of the integrated circuit 500. The integrated circuit 500 includes a first standard cell 502, a second standard cell 504, and coupling cell 506.

The first standard cell 502 and the second standard cell 504 can represent any standard cells that are selected from the predefined library of standard cells in a substantially similar manner as the first standard cell 502 and the second standard cell 504, respectively. However, the first active diffusion region 508 can be characterized as being a combination of a first active diffusion region portion 508.1 having a first width w₁ within the first standard cell 502, a second active diffusion region portion 508.2 between the first standard cell 502 and the second standard cell 504, and a third active diffusion region portion 508.3, having a second width w₂ that is different from the first width w₁, within the second standard cell 502. The second active diffusion region 510 can be characterized in a substantially similar manner as the first active diffusion region 508.

The coupling cell 506 couples the first active diffusion region portion 508.1 to the third active diffusion region portion 508.3 and the first active diffusion region portion 510.1 to the third active diffusion region portion 510.3 to provide substantially continuous active diffusion regions throughout the integrated circuit 500. Specifically, the coupling cell 506 provides a substantially continuous transition of the first active diffusion region portion 508.1 to the third active diffusion region portion 508.3 and a substantially continuous transition of the first active diffusion region portion 510.1 to the third active diffusion region portion 510.3. These substantially continuous transitions of the first active diffusion region 508 and the second active diffusion region 510 present a substantially continuous active diffusion region throughout the integrated circuit 500.

As shown in FIG. 5, the second active diffusion region portion 508.2 within provides a non-linear transition, such as a step or discrete transition, between the first active diffusion region portion 508.1 and the third active diffusion region portion 508.3 and the second active diffusion region portion 510.2 provides a non-linear transition between the first active diffusion region portion 510.1 and the third active diffusion region portion 510.3. However, the second active diffusion region portion 508 can provide linear transitions or any combination of linear and non-linear transitions between the first active diffusion region portion 508.1 to the third active diffusion region portion 508.3 and between the first active diffusion region portion 510.1 and the third active diffusion region portion 510.3.

These linear transitions and/or non-linear transitions can be modeled using Electronic Design Automation (EDA) software, such as SPICE to provide an example, to determine which transition leads to substantially uniform stress patterns throughout the integrated circuit 500 when stress is applied to the transistors of the integrated circuit 500. The EDA software represents a category of computer aided design tools for designing, simulating, and/or producing integrated circuit layouts. The EDA software can select among various widths w₁ through wₖ, linear transitions and/or non-linear transitions, and/or any other suitable integrated circuit layout parameter of the integrated circuit 500 that will be apparent to those skilled in the relevant art(s) to determine which integrated circuit layout leads to substantially uniform stress patterns throughout the integrated circuit 500 when stress is applied to the transistors of the integrated circuit 500.

The coupling cell 506 includes a p-type stressing transistor 512 and an n-type stressing transistor 514. The p-type stressing transistor 512 and the n-type stressing transistor 514 are substantially similar to the p-type stressing transistor 312 and the n-type stressing transistor 314, respectively. However, a first standard cell 502 and the second standard cell 504 can be mirrored images, such as shown in FIG. 3, of their respective integrated circuit layout that are shown in FIG. 5. In these situations, the p-type stressing transistor 512 and the n-type stressing transistor 514 can be configured and arranged to form a transmission gate in a substantially similar manner as the p-type stressing transistor 406 and the n-type stressing transistor 408.

### CONCLUSION

It is to be appreciated that the Detailed Description section, and not the Abstract section, is intended to be used to interpret the claims. The Abstract section can set forth one or more, but not all exemplary embodiments, of the disclosure, and thus, are not intended to limit the disclosure and the appended claims in any way.

The disclosure has been described above with the aid of functional building blocks illustrating the implementation of specified functions and relationships thereof. The boundaries of these functional building blocks have been arbitrarily defined herein for the convenience of the description. Alternate boundaries can be defined so long as the specified functions and relationships thereof are appropriately performed.

It will be apparent to those skilled in the relevant art(s) that various changes in form and detail can be made therein without departing from the spirit and scope of the disclosure. Thus the disclosure should not be limited by any of the above-described exemplary embodiments, but should be defined only in accordance with the following claims and their equivalents.

## Claims

1. An integrated circuit having a substantially uniform stress pattern throughout when stress is applied during fabrication, comprising:
a first standard cell having a first active diffusion region and a second active diffusion region, a first transistor from among a plurality transistors being configured to utilize the first active diffusion region for its active region and a second first transistor from among the plurality transistors being configured to utilize the second active diffusion region for its active region;
a coupling cell having a third active diffusion region coupled to the first active diffusion region and a fourth active diffusion region coupled to the second active diffusion region, a third transistor from among the plurality transistors being configured to utilize the second active diffusion region for its active region and a fourth transistor from among the plurality transistors being configured to utilize the fourth active diffusion region for its active region, the third transistor and the fourth transistor being further configured to be continuously inactive; and
a second standard cell having a fifth active diffusion region coupled to the third active diffusion region and a sixth active diffusion region coupled to the fourth active diffusion region, a fifth transistor from among the plurality transistors being configured to utilize the fifth active diffusion region for its active region and a sixth transistor from among the plurality transistors being configured to utilize the sixth active diffusion region for its active region.

2. The integrated circuit of claim 1, wherein at least one of: the first standard cell or the second standard cell is selected from a pre-defined library of standard cells.

3. The integrated circuit of claim 1 or 2, wherein the first, the third, and the fifth active diffusion regions are configured and arranged to form a first substantially continuous active diffusion region, and wherein the second, the fourth, and the sixth active diffusion regions are configured and arranged to form a second substantially continuous active diffusion region.

4. The integrated circuit of any preceding claim, wherein the first, the third, and the fifth semiconductor transistors are p-type metal-oxide-semiconductor (PMOS) transistors and wherein the second, the fourth, and the sixth semiconductor transistors are n-type metal-oxide-semiconductor (NMOS) devices.

5. The integrated circuit of any preceding claim, wherein the third transistor is configured to continuously receive a bias voltage between its gate and its source that is greater than its threshold voltage to cause the third transistor to be continuously inactive.

6. The integrated circuit of any preceding claim, wherein the gate and the source of the third transistor are coupled to each to cause the third transistor to be continuously inactive.

7. The integrated circuit of any preceding claim, wherein the fourth transistor is configured to continuously receive a bias voltage between its gate and its source that is less than its threshold voltage to cause the fourth transistor to be continuously inactive.

8. A coupling cell for coupling a first active diffusion region of a first standard cell to a second active diffusion region of a second standard cell, comprising:
a third active diffusion region coupled to the first active diffusion region and the second active diffusion region to form a substantially continuous active diffusion region throughout; and
a semiconductor device configured to utilize the substantially continuous active diffusion region for its respective active region, the semiconductor device being configured to be inactive.

9. The coupling cell of claim 8, wherein the semiconductor device comprises:
a p-type metal-oxide-semiconductor (PMOS) device configured to continuously receive a bias voltage between its gate and its source that is greater than its threshold voltage to cause the PMOS device to be continuously inactive or to receive a control signal at the gate that is greater than the threshold voltage to cause the PMOS device to be temporarily inactive.

10. The coupling cell of claim 9, wherein the source of the PMOS device is coupled to the gate.

11. The coupling cell of any of claims 8 to 10, wherein the semiconductor device comprises:
a n-type metal-oxide-semiconductor (NMOS) device configured to continuously receive a bias voltage between its gate and its source that is less than its threshold voltage to cause the NMOS device to be continuously inactive or to receive a control signal at the gate that is less than the threshold voltage to cause the NMOS device to be temporarily inactive.

12. The coupling cell of claim 11, wherein a source of the NMOS device is coupled to the gate.

13. The coupling cell of any of claims 8 to 12, wherein a width of the first active diffusion region is different from a width of the second active diffusion region, and
wherein the third active diffusion region is configured to provide a substantially continuous transition from the first active diffusion region to the second active diffusion region.

14. The coupling cell of claim 13, wherein the substantially continuous transition is a substantially non-linear transition.

15. An integrated circuit having a substantially continuous active diffusion region throughout, comprising
a first plurality of semiconductor devices configured to utilize the substantially continuous active diffusion region for their active regions, the first plurality of transistors having a first integrated circuit layout that is selected from a pre-defined library of standard cells;
a second plurality of semiconductor devices configured to be continuously inactive and to utilize the substantially continuous active diffusion region for their active regions; and
a third plurality of semiconductor devices configured to utilize the substantially continuous active diffusion region for their active regions, the third plurality of transistors having a second integrated circuit layout that is selected from the pre-defined library of standard cells.
